# EUROPEAN PATENT APPLICATION

(11) **EP 1 211 544 A2**
(43) Date of publication of application: **05.06.2002**
(21) Application number: 01127668.0
(22) Date of filing: 20.11.2001
(51) Int. Cl.: G02B 26/02, G02B 6/26, G02B 27/10

(54) **A variable optical attenuator and beam splitter**

(30) Priority: 04.12.2000 US 250516 P; 12.03.2001 US 802929
(71) Applicant: Memlink Ltd., Herzlia Pituach 46733 (IL)
(72) Inventor: Chertkow, Igal Roberto, Ashdod 77709 (IL); Messica, Avi, Holon (IL); Patlakh, Anatoly, Tel Mond, 40660 (IL)
(74) Representative: Becker Kurig Straus

(57) **Abstract**

A microelectromechanical (MEMS) device has a substrate (102), and at least one, generally planar moving element (106), such as an absorber or a mirror, disposed in parallel to the surface of the substrate. An actuator is operatively engageable with the moving element for selectively actuating the moving element between a series of successive, closely spaced positions in a plane horizontal to the surface of the substrate. The MEMS device may be effectively used as a variable attenuator and beam splitter. Various different actuators can be used. Preferably, the device is fabricated using a surface micromachining process.

## Description

### FIELD AND BACKGROUND OF THE INVENTION

The present invention relates to the field of microelectromechanical systems (MEMS) and, more particularly, to microelectromechanical or micromechanical devices that actuate a moving element between operative positions to provide, for example, an attenuating or beam splitting operation.

A MEMS device is a micro-device that is generally manufactured using integrated circuit fabrication or other similar techniques and therefore has the potential for cost-effective, large-scale production. A MEMS device is a high precision system used to sense, control, or actuate on very small scales by combining mechanical, electrical, magnetic, thermal and/or other physical phenomena. It typically includes a tiny mechanical device element such as a sensor, mirror, valve, or gear that is embedded in or deposited on a semiconductor chip or substrate. These systems may function individually, or they may be combined in array configurations to generate effects on a larger scale. Advantageously, a MEMS device may be monolithically integrated with driving, control, and/or signal processing microelectronics to improve performance and further reduce the cost of manufacturing, packaging, and testing the device. As used herein, the term "MEMS device" is intended to embrace devices that are physically small and have at least one component produced using micromachining or other microfabrication techniques, and the term MEMS device includes microactuators, micromechanical devices, and micromachine devices.

Due to their considerable technological potential, the use of MEMS is currently being pursued in many different fields. In particular, high precision MEMS are receiving an increasing amount of interest in the fiber-optics field because of their capability to overcome several limitations associated with prior art technologies: see generally Motamedi et al., "Micro-opto-electro-mechanical devices and on-chip optical processing", *Optical Engineering,* vol. 36, no. 5, p. 1282 (May 1997), the contents of which are incorporated herein by virtue of this reference.

In fiber-optic communication systems, information is transmitted as a light or laser beam along a glass or plastic wire, known as a fiber. A significant amount of electronic communication and information transfer is effected through fiber-optic lines due to their much broader bandwidth and lower susceptibility to electromagnetic interference compared to conventional copper or metal wires. For example, much of the Internet and many long distance telephone communication networks are connected with fiber-optic lines. Optical communication requires a variety of devices for controlling the light beam; a variable optical attenuator and a beam splitter are common devices used for such control. Variable optical attenuators are used in such networks to control the power of an optical signal, and have in the past been implemented in various designs. The present invention relates to beam attenuation in optical communications networks and, more particularly, to a micromechanical valve that can be actuated (moved) in a controlled series of small steps, thus providing a function of controlled attenuation of a light beam. If the valve is provided with a reflecting surface (mirror) and a beam hits it at an angle, the valve can act as a beam splitter.

Past designs of variable optical attenuators include (but are not limited to) inserting a rotatable disk between a pair of optical fibers (U.S. Pat. No. 4,591,231 to Kaiser et al.), changing the orientation between two fibers, inserting a thin film with a changing optical density in the beam path (U.S. Pat. No. 4,904,044 to Tamulevitch), or using a flexural mirror (U.S. Pat. No. 5,915,063 to Colbourne et al.). Recently, variable attenuators have been miniaturized and implemented using MEMS techniques, for example by Bergman and Bishop in U.S. Pat. No. 6,163,643, by Aksyuk et al. in U.S. Pat. No. 6,148,124, and by Robinson in U.S. Pat. No. 6,137,941. Since the present invention also uses MEMS attenuators, it can only be compared to these recent devices. Both Aksyuk's and Bergman and Bishop's patents use focusing optics for a beam which is basically parallel to a substrate, and a vertical attenuator moving along the substrate and cutting the beam path. Thus both are limited to a linear configuration, and lack the flexibility allowed by two- or three-dimensional stacking of attenuator arrays, as potentially enabled by the present invention. Robinson's device is a pivotable MEMS mirror mounted on a substrate, which controls the attenuation of a focused perpendicular light beam by deflecting varying amounts of the beam, and is again useful only in a two-dimensional system, since an array of mirrors is mounted on one planar substrate. All three patents suffer from a major disadvantage in that they provide a low movement resolution, i.e. a limited number of intermediate positions or "steps" in the movement of the attenuator device, unlike the preferably 300 closely spaced (about 1 micrometer apart) steps of the present invention. Thus, the mirror in Bergman and Bishop's patent is located at the focal plane, and has very limited movement range. In Aksyuk's patent, the attenuator can assume a very small number of intermediate positions, and the attenuation is in fact quite constant, and not very variable. The attenuation in Robinson's system is driven by pulse modulation, a method that can lead to loss of information, a major disadvantage in a communications system. None of the previous MEMS-type attenuators allows the controlled shaping of the cross section of a beam, e.g. the peripheral blocking of any desired portion of a Gaussian shaped beam, as does one embodiment of the attenuator of the present invention. Present products thus have several limitations regarding geometry, flexibility of function, design, performance, etc.

In addition, in prior art MEMS devices that actuate a moving element, the design of the actuator and the mechanical coupling of the actuator to the moving element typically generate a significant amount of dynamic friction during actuation: see for example Akiyama et al., "A Scratch Drive Actuator with Mechanical Links for Self-Assembly of Three-Dimensional MEMS", *Journal of Microelectromechanical Systems,* vol. 6, no. 1, p. 10 (March 1997). As such devices are operated over time, the dynamic friction tends to wear the device components and reduce the reliability and positioning accuracy of the device. Similarly, the moving element of these MEMS devices are generally attached to the substrate or a support component of the device by means of weights, springs, clamps, or other like mechanisms. Again, because these parts are in physical contact with one another, there is dynamical friction during actuation and the parts may wear, leading to reduced device accuracy. Positioning accuracy and repeatability are particularly important for variable attenuators and splitters (e.g. in returning repeatably to a position dictated by a look-up table or LUT), and these attributes are, as emphasized above, generally lacking in prior art.

There is therefore a need for an improved MEMS device capable of rapidly and efficiently actuating to a series of controlled, closely spaced positions, a generally flat moving element such as a mirror or absorber to provide, for example, a variable attenuator or beam splitter operation. It would further be desirable if such a MEMS device were not susceptible to wear from dynamic friction effects and exhibited minimal insertion loss.

### SUMMARY OF THE INVENTION

The present invention provides a MEMS device having a generally planar moving element disposed in parallel to the surface of a substrate; and an actuator operatively engageable with the moving element for selectively step-moving the element in a series of successive, closely spaced operative positions in a plane parallel with the surface of the substrate. The substrate includes a zone that is penetrable by the optical beam, such zone preferably being an aperture formed within the substrate or comprising an optically transparent material. The moving element preferably travels in a linear path. Specifically, the present invention employs novel control and structural features to provide a light beam variable attenuation function presently unavailable from any known competitive MEMS techniques. The invention takes advantage of a novel feature in the valve technology described in the parent application, in which the actuation of the valve from an operative position yielding an open aperture to an operative position yielding a close aperture can be done in a plurality of very small steps, for example any number between 1 and 300 steps. In the particular example discussed hereinbelow, 300 steps are the maximum needed for a full movement of the valve. It is understood that this number is for exemplary purposes only, and that the number of maximum steps can vary in a wide range, from ca. 10 to ca. 500.

In a preferred embodiment, the device is particularly suitable for use as an optical attenuator where the moving element alters the intensity and/or the shape of an optical beam. In this case, the moving element preferably comprises an absorber, although it can also comprise a mirror or non-absorber material. In another preferred embodiment, the device is particularly suitable for use as a beam splitter, and in this case, the moving element preferably comprises a mirror.

In a preferred embodiment, the actuator comprises a plurality of elongated actuating beams spaced perpendicularly to and along a travel path of the moving element. Each beam extends substantially parallel to the surface of the substrate and has a tip, and a base that is rigidly fixed with respect to the substrate. The actuator further includes a beam actuator that controllably moves the actuating beams so that the beams that are positioned along the portion of the travel path in which the moving element is located intermittently engage the moving element and thereby move the moving element in a step-wise fashion in a desired direction along the travel path. The beams are preferably conductive and the beam actuator preferably comprises, for each actuating beam: at least one first electrode mounted to the substrate and positioned vertically from that actuating beam with respect to the surface of the substrate; at least one second electrode mounted to the substrate and positioned horizontally from the actuating beam with respect to the surface of the substrate; and circuitry for controllably generating a first electric field between the at least one first electrode and the actuating beam to move that actuating beam in a vertical direction with respect to the surface of the substrate, and a second electric field between the at least one second electrode and the actuating beam to move that actuating beam in a horizontal direction with respect to the surface of the substrate.

Where the travel path is linear and has first and second edges, the plurality of actuating beams preferably comprises a first set of actuating beams spaced along the first edge of the travel path; and a second set of actuating beams spaced along the second edge of the travel path, the beam actuator controllably moving the tips of the beams in the first set synchronously with the tips of the beams in the second set. In each of the first and second sets, adjacent ones of the actuating beams that are located along the edge of the portion of the travel path in which the moving element is located may rotate out of phase so that the intermittent engagement of the moving element by adjacent tips in each set is successive. Alternatively, where the moving element rests on static support members fixed to the substrate, in each of the first and second sets, the actuating beams that are located along the edge of the portion of the travel path in which the moving element is located may rotate in phase so that the intermittent engagement of the moving element by said beams in each set is simultaneous.

Other actuators may also be used. In all embodiments, the moving element preferably includes a conductive component, and the device further comprises at least one substrate electrode and circuitry for generating an electric field between the conductive component and the substrate electrode or electrodes to hold the moving element by means of static friction (also referred to as virtual or artificial gravity).

The device is preferably fabricated using micromachining techniques, and with the moving element fabricated in a position parallel to the surface of the substrate. More preferably, surface micromachining techniques are employed in which a plurality of material layers are sequentially deposited and etched. Arrays of the devices may also be provided on a common substrate, each device having its own moving element and actuator. Other objects, features, and advantages of the present invention will become apparent upon reading the following detailed description of the embodiments with the accompanying drawings and appended claims.

According to the present invention there is provided a MEMS device comprising: (a) a substrate having a surface; (b) at least one generally planar moving element disposed in parallel to the surface of the substrate; and (c) an actuator operatively engageable with the at least one moving element for selectively moving the at least one element between a series of successive closely spaced operative positions in a plane horizontal to the surface of the substrate.

According to the present invention there is provided an array of MEMS devices on a substrate having a surface, each of the MEMS devices comprising: (a) at least one generally planar moving element disposed in parallel to the surface of the substrate; and (b) an actuator operatively engageable with the at least one moving element for selectively moving the at least one element between successive, closely spaced operating positions in a plane horizontal to the surface of the substrate.

### BRIEF DESCRIPTION OF THE DRAWINGS

The objects and advantages of the present invention will be better understood and more readily apparent when considered in conjunction with the following detailed description and accompanying drawings which illustrate, by way of example, preferred embodiments of the invention and in which:
Fig. 1 is an isometric view of the general configuration of a MEMS device in accordance with the present invention;
Fig. 1A is a cross-sectional view of the device taken along the line 1A-1A in Fig. 1;
Fig. 2 shows the shape and motion of a moving element of the device in a preferred embodiment of the present invention;
Fig. 3 shows an alternative shape and motion of the moving element;
Fig. 4 shows the substrate of an optical attenuator or beam splitter MEMS device;
Fig. 4A shows a transparent zone etched through the substrate and surrounded by a non-transparent zone.
Figs. 5A-5C illustrate the operation of the MEMS device of the present invention as a variable attenuator;
Figs. 6A-6B illustrate the operation of the MEMS device of the present invention as a variable beam splitter/attenuator;
Fig. 7 shows a preferred configuration for holding the moving element to the actuator of the device;
Fig. 8 is a top plan view of the MEMS device of the present invention comprising preferred actuator that uses actuating beams;
Figs. 9A-9B show cross-sectional side views of the device and actuator of Fig. 8;
Figs.10A-10B illustrate the relative positioning of an actuating beam and corresponding electrodes for electrostatically actuating the beam;
Figs. 11A-11F show and illustrate the operation of the actuator of Fig. 8;
Figs. 12A-12B illustrate the operation of an actuator based on a variation of the actuator of Fig. 8;
Fig. 13 illustrates a top view of a possible adaptation to the actuator of Figs 12A-12B to ensure that the moving element's motion is linear;
Figs. 14A-14D illustrate the operation of another possible actuator for use in the MEMS device of the present invention;
Figs. 15A-C illustrate a preferred two-valve configuration of the variable attenuator MEMS device of the present invention;
Figs 16A-16I illustrate possible steps in fabricating the MEMS device of the present invention.
Fig. 17 shows an isomeric view of a two-dimensional attenuating/splitting device comprising a 3 x 3 array of variable attenuator/splitter MEMS devices.

### DETAILED DESCRIPTION OF PREFERRED EMBODIMENTS

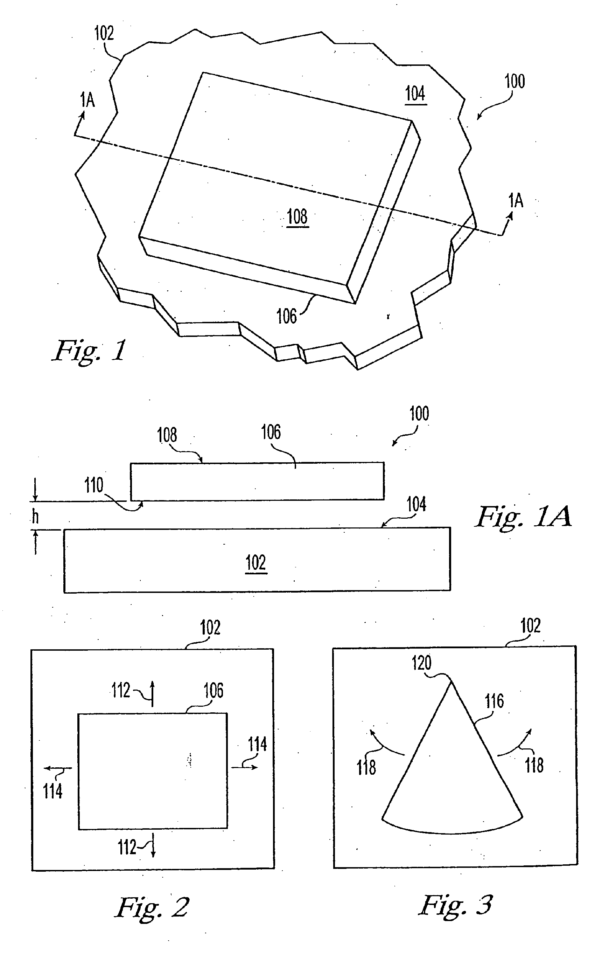

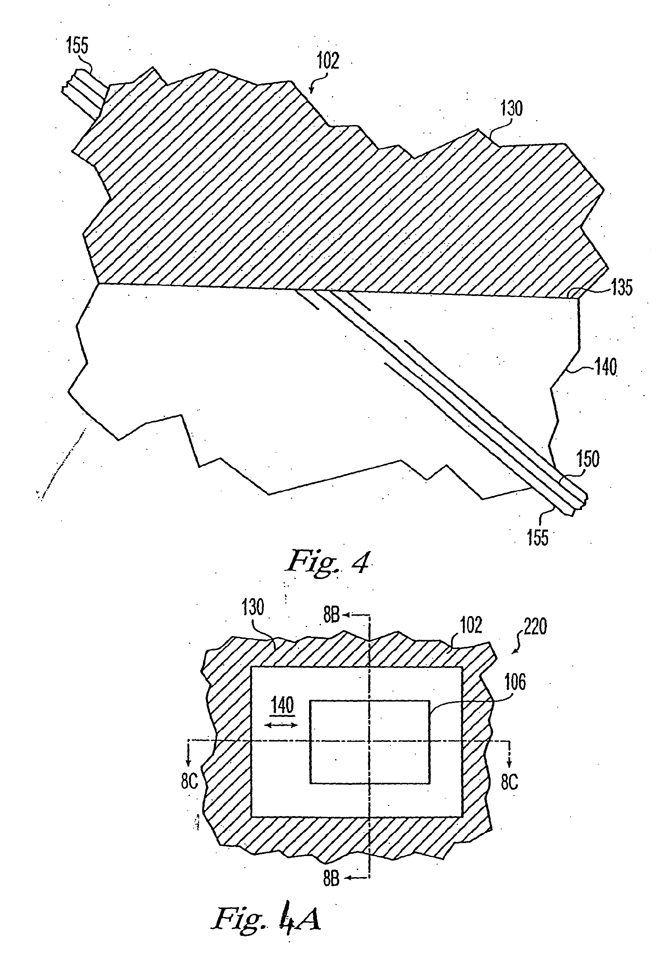

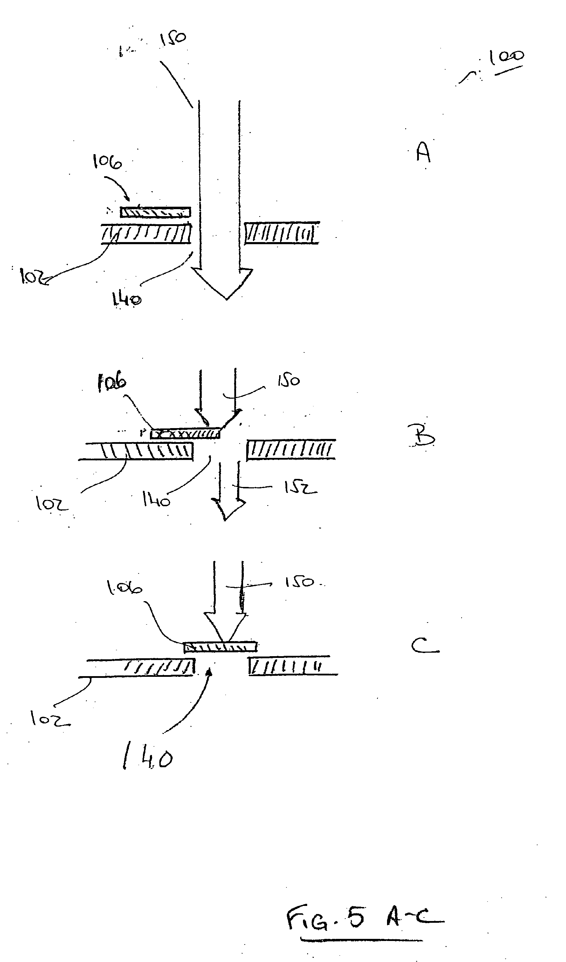

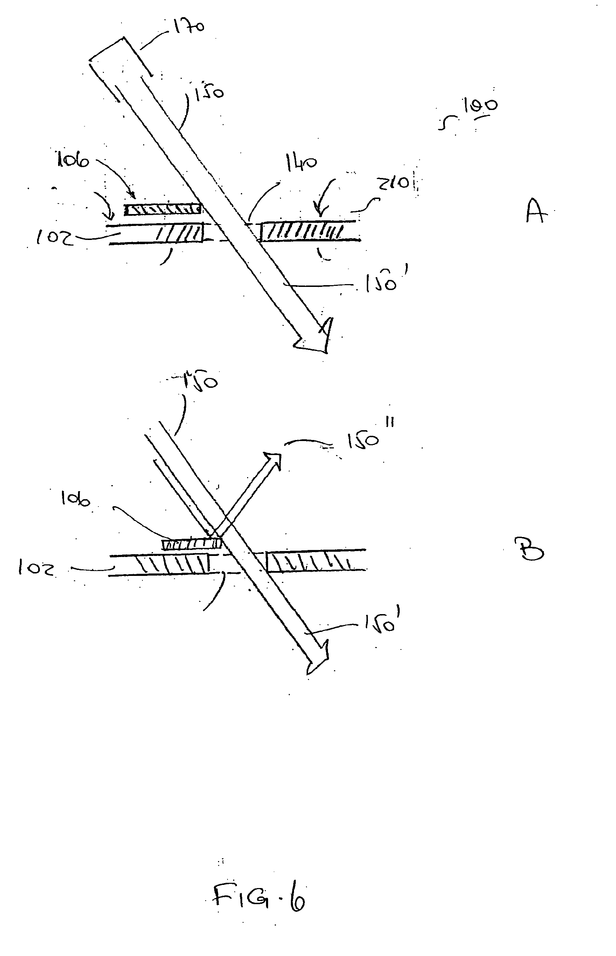

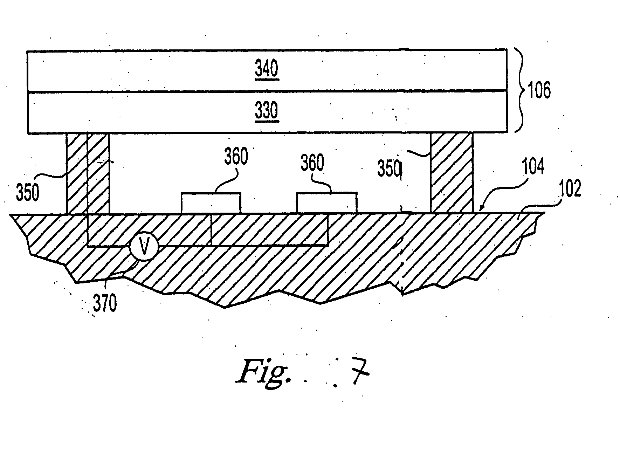

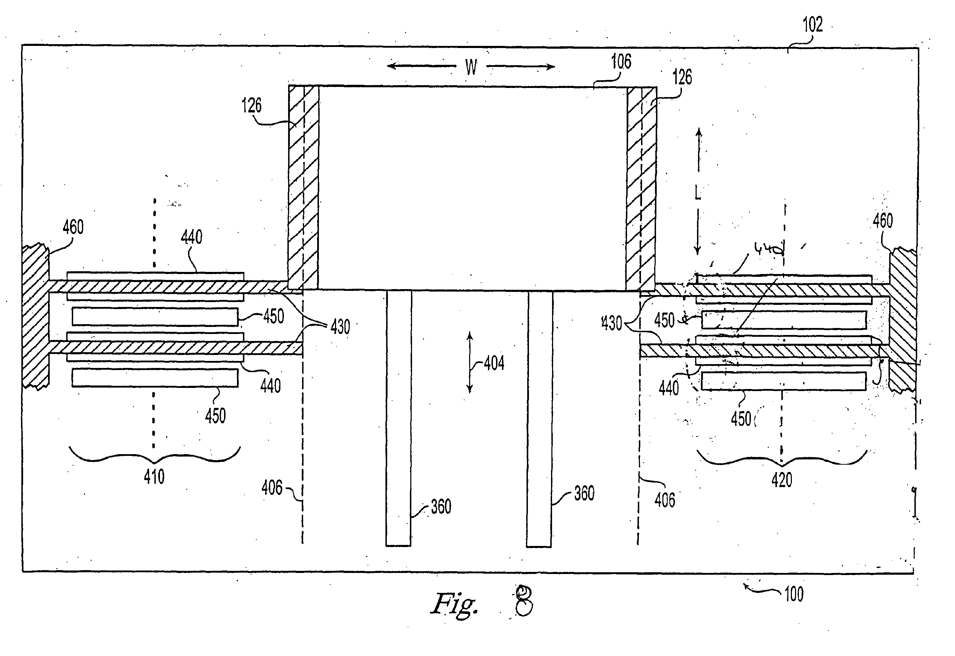

Fig. 1 shows an isometric view of the general configuration of a MEMS valve device **100** as disclosed in the parent application. The device **100** includes a substrate **102** having a surface **104.** A moving or switching element **106** has a generally flat main portion is disposed in parallel to the substrate **102,** above the surface **104.** As described in detail below, moving element **106** may also have support wings, legs or other appendage-like members that are connected to the main portion of element **106** (not shown in Fig. 1). A cross-sectional view of the device **100** taken along the line 1A-1A in Fig. 1 is shown in Fig. 1A. Referring to Figs. 1 and 1A, the main portion of moving element **106** has a first major surface **108** facing away from substrate **102** and a second major surface **110** that faces substrate **102,** and more specifically surface **104** of substrate **102.**

As shown, moving element **106,** or more specifically the main portion thereof, is preferably separated from substrate **102** by a short distance **h.** As described in detail below, when device **100** performs an attenuation or beam splitting operation, element **106** is selectively moved to a different operative position in the horizontal plane located a distance **h** above substrate **102.** While moving between operative positions in the horizontal plane, i.e. during actuation, moving element **106** may temporarily leave the horizontal plane. Furthermore, moving element **106** may be located on the surface **104** of substrate **102** above an aperture therein (i.e. **h** may be positive or may equal zero), moving element **106** may be recessed within an aperture of substrate **102** (i.e. **h** may be slightly negative), or moving element **106** may be located on the other side of substrate **102** (i.e. **h** may have a relatively large negative value). In all embodiments, however, moving element **106** is disposed horizontally or in parallel to substrate **102.**

MEMS device **100** is particularly suitable for use as an attenuator or a beam splitter in a fiber optic communication network. When used as an attenuator and/or a beam splitter, moving element **106** is used to selectively absorb, attenuate, reflect or otherwise alter or modulate the properties and/or path of a light beam. Consequently, moving element **106** may include means for altering the characteristics of a wave incident upon it, i.e. reduce the wave intensity, change the wave shape or reflect (split) part or all of the wave into a direction different from the original direction. Such means may include (but not be limited to) element **106** being an absorber, optical mirror, attenuator, filter, or beam splitter, or element **106** having a shape such as a V-shaped leading edge, for example, or any other suitable shape.

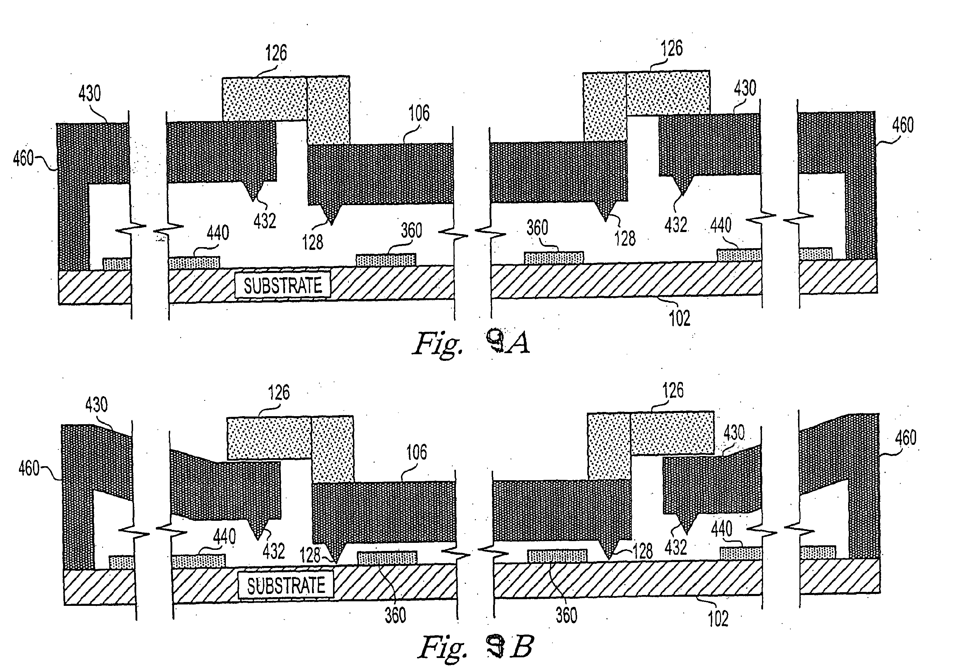

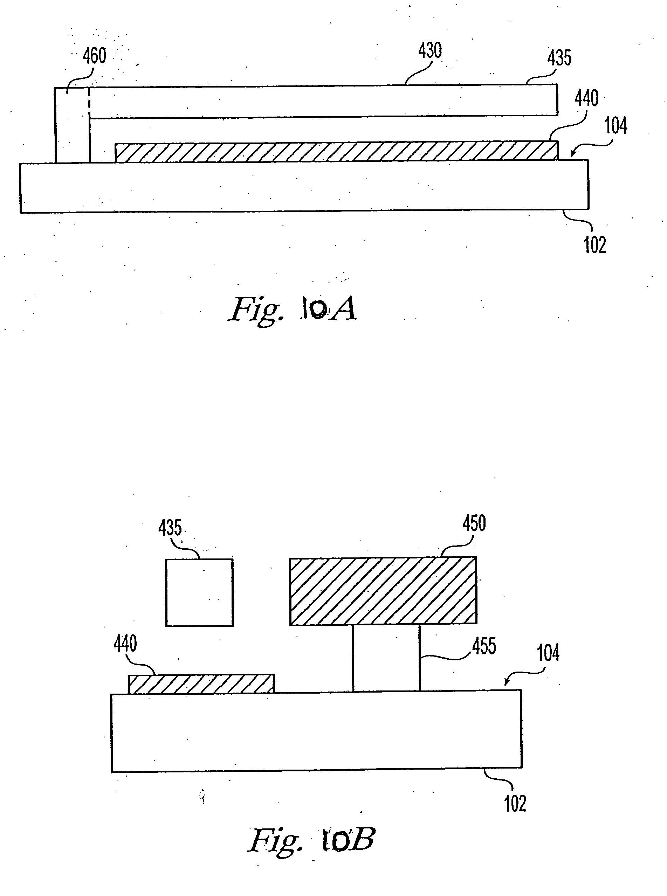

As shown in the embodiment of Fig. 2, moving element **106** may be rectangular and may move in a linear direction within a travel path, defining a range of travel, in the horizontal plane. For example, element **106** may have a travel path along the line defined by arrows **112** or the line defined by arrows **114.** More generally, moving element **106** may move in any linear direction within the horizontal plane. In an alternate embodiment shown in Fig. 3, the moving element may be sector-shaped, as shown at **116,** or circular shaped (not shown), and may move in a radial or pendulum-like motion about a point **120,** as shown by arrows **118**. As a further alternative, the motion of element **106** may be a combination of rotational and translational motion. As indicated, the main portion of moving element **106** is generally flat but otherwise may be of a shape other than those shown in Figs. 2 and 3, such as circular or elliptical. Substrate **102** is a semiconductor wafer substrate that may be fabricated using well-known integrated circuit processing techniques. The substrate is preferably silicon based, but other materials such as glass, polymers, or metals may also be used. An actuator, which may comprise microelectronic components, is preferably built in or on substrate **102** and serves to actuate the desired movement of moving element **106,** as described in detail below. Substrate **102** is preferably produced with atom smooth surfaces and a high degree of parallelism and linearity. As shown in Fig. 4, in the case of an optical attenuator or beam splitter, substrate **102** may include a first zone **130** through which an input light beam **150** from an exemplary optical fiber **155** does not penetrate, and a second zone **140** that is transparent to light beam **150.** A baseline **135** separates the zones **130** and **140.** The actuation of element **106** preferably occurs at least partially above the second zone **140,** and in a direction parallel to or perpendicular to baseline **135.** The second zone **140** may, for example, comprise a transparent glass. Alternatively, the substrate may simply be absent in zone **140,** as long as sufficient structural support for device **100** is otherwise provided. For instance, zone **140** may be a hole or aperture etched through substrate **102,** and which is surrounded by zone **130** (e.g. see Fig. 4A). Generally, zones **130** and **140** may be located on substrate **102** in any number of ways, and it is also possible for substrate **102** to have more than one zone **130** and/or zone **140** which are not contiguous. For example, two non-penetrable substrate zones **130** may be separated by a single penetrable zone **140.** As a further alternative all of substrate **102** may comprise an optically transparent material such as glass.

Figs. 5A-C illustrate the operation of device **100** as a variable attenuator, in which moving element **106** is either an absorber or a mirror. In Fig. 5A, moving element **106** is in a first ("open") position and light beam **150** that preferably impinges perpendicularly (normally incident) on substrate travels unimpeded through transparent zone **140.** When moving element **106** is translated, parallel to substrate **102,** to one of n (more "closed") positions defined by the number of basic steps in the stepped movement of the actuator (n being preferably 300 steps), e.g. step number 150 of 300 as shown in Fig. 5B, part of light beam **150** is attenuated, either absorbed in moving element **106,** or reflected away. An attenuated beam **152** that passes through zone **140** thus includes less intensity, or is truncated and changed in shape, to a degree dependent on the position of moving element **106** relative to zone **140.** For example, in Fig. 5C, element **106** is shown positioned at the end of its travel range (step 300 out of 300 in the preferred embodiment discussed), totally blocking (attenuating) light beam **150.** The attenuation is almost continuously variable due to the high resolution of the movement of element **106** (a distance of about 1 µm between discrete operative positions, as explained below), providing a feature unavailable in any competitive MEMS device.

Figs. 6A and 6B illustrate the operation of device 100 as a beam splitter/attenuator **210** in which moving element **106** is preferably a mirror. As with the attenuator above, in Fig. 6A, moving element **106** is in a first ("open") position and light beam **150** from an input source **170** travels unimpeded through transparent zone **140** in substrate **102** as a continuing, first output beam **150'.** When moving element **106** is translated, parallel to substrate **102,** to one of n (more "closed") positions, e.g. step number **150** as shown in Fig. 6B, a portion of light **150** reflects off (is split from) of the surface of mirror **106** and is directed as a secondary, second output beam **150".** In this mode of operation, light beam **150** is not normally incident upon the surface of mirror **106** but rather has an angle of incidence (i.e. the angle between the normal to the mirror surface and the light) that is greater than zero. In a preferred embodiment, the angle of incidence of light beam **150** is about 45°. As will be appreciated by those skilled in the art, when beam splitter **210** is actuated from the first position to a series of successively more closed positions, the amount of light in continuing beam **150'** decreases almost continuously, while the amount of light split into secondary beam **150"** increases almost continuously. Thus, one achieves both a variable attenuation of beam **150** in the direction of first output beam **150',** and increased transmission of secondary beam **150".** In other words, the moving element alters the characteristics of an optical beam in a stepped varying fashion when moving between successive operative positions.

Furthermore it will be appreciated by those skilled in the art, that beam splitter **210** can be actuated in the opposite direction, from the first position in which the aperture **140** is totally covered to a series of successively more opened positions. In this case the main beam is the reflected beam **150"** and the secondary beam is the continuing beam **150'.** The amount of light in continuing beam **150'** increases almost continuously, while the amount of light into the main beam **150"** decreases almost continuously. Thus, one achieves both a variable attenuation of beam **150** in the direction of main output beam **150",** and increased transmission of secondary beam **150'.** In other words, the moving element alters the characteristics of an optical beam in a stepped varying fashion when moving between successive operative positions.

It should be noted that the light beams may travel through any of the attenuators described above in the reverse direction to that illustrated, that is with the input and output beams reversed.

The present invention may use a number of different types of actuation approaches for selectively changing the position of each moving element 106 in device **100**. Generally, the actuator transforms electrical or thermal energy into controllable motion (as indicated above, at least part of the actuator is preferably located in or on substrate **102).** The preferred actuation approach may depend on the type of moving element used. In particular, the actuator may be based on the following types of actuation principles: thermomechanical; shape memory alloys (SMA) with thermal actuation; electromagnetic; electrostatic; or piezoelectric (other actuation principles such as those based on magnetic, diamagnetic, mechanical, or phase change principles may also be used).

These microactuation principles are well known in the art: see generally R.G. Gilbertson et al, "A survey of Micro-Actuator Technologies for Future Spacecraft Missions", *Practical Robotic Interstellar Flight: Are We Ready? Conference*, New York, (August-September 1994), the contents of which are incorporated herein by virtue of this reference. Briefly, thermomechanical actuation is based on the physical expansion or contraction that occurs in materials when they undergo temperature variations. Shape memory alloy (SMA) effect actuation is based on changes in material properties that arise in some metal alloys (such as nitinol) when they are cycled above or below a certain transition temperature. SMA effect shape changes are generally much greater and occur over a much smaller temperature range compared to thermal expansion/ contraction. Both these types of thermally driven actuators require cooling, either passive or active, to reverse their actuation action.

Electromagnetic actuation is based on electric current moving through a conducting material. Advantages of electromagnetic actuation include the very rapid generation of forces and operation that is relatively independent of temperature. However the efficiency of electromagnetic actuation decreases significantly on the micro-scale, and it may be difficult to fabricate and appropriately position small electromagnetic coils in a MEMS device. Electrostatic actuation is based on the attraction of oppositely charged objects and repulsion between similarly charged objects. Electrostatic forces also arise very rapidly and are relatively temperature-independent. Electrostatic actuation is also highly efficient over small distances. Piezoelectric actuation is based on the mechanical force and motion that arise from the dimensional changes generated in certain crystalline materials when subjected to voltage or charge. Typical piezoelectric materials include quartz, lead zirconate titanate, and lithium niobate. Piezoelectric materials respond very quickly and with high forces to changes in voltage potentials.

Generally, the actuator should provide for stable and accurate positioning of the moving element **106** at each of its operative (or **n** stable state) positions. In addition to using one of the above mentioned actuation principles to move the element **106** from one operative position to another, the same or a different principle may be used to maintain the moving element in one of its **n** stable states. Preferably, electrostatic means are used to hold the moving element in its desired position as described in connection with Fig. 7 below.

The preferable attachment technique illustrated in Fig. 7, provides an electrostatic attraction between moving element **106** and the substrate, actuator, and or support structure (i.e. the fixed components) of device **100.** In Fig. 7, moving element **106** comprises a conductive component **330** and a functional component **340** (e.g. a mirror or an optical absorber). If necessary, components **330** and **340** of moving element **106** may be separated by an additional insulating layer. Optionally, element **106** can comprise a single component of a material capable of providing both the conducting and the desired optical function.

As shown in Fig. 7, moving element **106** rests on two posts **350** located on top of substrate surface **104.** Posts **350** may be formed by etching within the substrate **102** or may be deposited on top of substrate **102** during fabrication, for example. Two electrodes **360** are also located on top of substrate surface **104** (alternatively electrodes **360** may be located underneath or within surface **104).** Although electrodes **360** are shown to be positioned between posts **350,** they may generally be positioned anywhere along surface **104** as long as they are at least approximately underneath moving element **106** (for instance, electrodes **360** may be positioned outwardly of posts **350** in Fig. 7). By applying, for example, suitable voltage difference **370,** the conducting component **330** can be made more positively charged and substrate electrodes **360** more negatively charged (or vice versa), resulting in an electrostatic field that maintains moving element **106** against posts **350.** For example, conducting component **330** can be charged to a voltage above a certain reference level (i.e. ground), and substrate electrodes **360** can be charged to a voltage below that reference level. Signal **370** can again be provided by suitable microelectronic circuitry located in or on substrate wafer **102.** In an alternative embodiment, fixed electrodes **360** are oppositely charged by connecting a potential difference between them. Localized charges are thereby induced on conducting component **330** so that element **106** is electrostatically sustained and attached to posts **350.**

Again, it should be noted that the upper direction in Fig. 7 is not necessarily against the direction of gravity, and device **100** can be positioned in any orientation, with the electrostatic force between electrodes **360** and conducting component **330** providing a "virtual gravity" effect on moving element **106.** A further advantage of the attachment configuration of Fig. 7 is the absence of a direct electrical contact between moving element **106** and the substrate electrodes **360.** Additionally, moving element **106** is not restricted to particular connecting points, and the attachment force provided by the potential difference **370** can be adjusted as desired. As a result, this preferred attachment mechanism for element **106** permits device **100** to function in any orientation, without relying on gravity and without requiring the use of springs (or other connection components) that may produce dynamic friction during actuation, resulting in wear, or the use of bearing-like parts that are difficult to fabricate in micro dimensions.

In one preferred implementation, the actuator may comprise a number of independently controllable (or actuable) members for selectively engaging moving element **106.** Each member preferably has a base end connected to substrate **102** an another free end or tip that is selectively or operatively engageable with moving element **106.** The members, or their free ends, may be controllably moved by way of any one of the actuation principles mentioned above (e.g. electrostatic, piezoelectric, thermomechanical, etc.) to carry moving element **106** in a desired direction. In doing so, the actuator members may engage moving element **106** in succession or simultaneously depending on the specific details of actuator operation.

For example, Fig. 8 shows a top plan view of a preferred configuration of MEMS device **100** having an actuator **400** having two sets **410** and **420** of actuating beams **430.** Beams **430,** which act as fingers or cantilevers, are generally elongated, and preferably of a rectangular or square cross-section, at least near the tips thereof. Each set **410, 420** comprises a number of beams **430,** although, for clarity of illustration in Fig. 8, only two beams **430** are shown in each of sets **410** and **420.** However, the presence of additional beams is intended to be indicated by the ellipses, as shown, so that, in general, beams **430** extend along substantially the entire travel path of element **106**, preferably near the edge or side of that path. The line of travel of element **106** is represented by the double-headed arrow **404,** and the associated travel path of moving element **104** has edges at **406,** as shown in Fig. 8. For example, in one preferred embodiment moving element **106** is of 300 µm in length (L), 300 µm in width (W), and about 2 µm in thickness and travels a horizontal distance of about 1 µm between operative positions (e.g. the "stable positions" of the attenuator or beam splitter). For the exemplary dimensions, each set **410, 420** of actuating beams may have between 15-20 equally spaced-apart beams **430,** each having a length of 150 µm and a 2 µm by 2µm cross-section. However, any number of beams of different shapes and sizes may be used, depending on the size and application of device **100** and element **106,** and the above example is in no way intended to be restrictive.

As shown in the top plan view of Fig. 8, and more clearly in the cross-sectional side views Figs 9A-9B, moving element **106** preferably includes wings **126** extending perpendicular to the line of travel of element **106** from opposite ends thereof. Each wing **126** is supported by a subset of the beams **430** in set **410** or set **420.** At different positions within its range of travel (i.e. along its travel path), element **106** is supported by different subsets of beams **430.** By actuating the beams **430,** or more specifically the distal ends or tips of beams **430,** in a systematic and controlled manner, element **106** is moved in a desired direction. Electrodes **360** located in or on substrate **102** serve to hold or attach element **106** in place. For this purpose, element **106** may include a conductive component as described in connection with Fig. 7 (but not shown in Fig. 8). Where MEMS device **100** is an optical variable attenuator or beam splitter, the portion of substrate **102** between electrodes **360** may be penetrable, i.e. transparent, to light, as described above in connection with Fig. 4.

In each set **410, 420,** the base end of each beam **430** is preferably connected to a single anchor or base portion **460** on substrate **102.** Alternatively, however, the base of each beam **430** may be connected to an individual anchor portion that is separately connected to substrate **102.** Other configurations may also be used to rigidly fix the base of each actuating beam **430** with respect to substrate **102.** As shown in Figs. 9A-9B, moving element **106** may include fin-like legs **128** extending toward substrate **102,** and similarly, each beam **430** may include a fin like leg **432** at the tip of the beam (i.e. the end of the beam away from base portion **460)** also extending toward substrate **102.** These legs ensure that there is no physical contact between beams **430** or moving element **106** and the electrodes on the surface **104** of substrate **102** (or substrate **102** itself). Legs **128** and **432** thereby serve to avoid any sticktion or short circuits, but may be omitted if this is not a concern.

Beams **430** may be actuated by any suitable actuation principle, however, electrostatic actuation is preferably used, and therefore actuating beam **430** are preferably conductive. As illustrated in Fig. 8, to provide electrostatic actuation, each beam **430** has a bottom electrode **440** and a side electrode **450** associated therewith. The corresponding bottom electrode **440** preferably lies along substrate **102,** underneath each beam **430,** as is shown in Figs. 10A-10B. Fig. 10B further illustrates the positioning of a corresponding side electrode **450** for each actuating beam **430.** Side electrode **450** preferably includes a support **455** so that side electrode **450** is generally at the same height as beam **430** with respect to the surface **104** of substrate **102.** The tip of the actuating beam can be actuated away from substrate **102** by making both the beam **430** and bottom electrode **440** more positively (or negatively) charged than a reference. The tip may also be actuated away from the substrate by its inherent elasticity, or by being pulled electrostatically by another electrode. Conversely, the tip of the actuating beam can be actuated towards substrate **102** by making one of beam **430** and bottom electrode **440** more positively charged than a reference and the other more negatively charged than the reference. Similarly, the tip of the actuating beam can be actuated in the direction towards side electrode **450** by making one of beam **430** and side electrode **450** more positively charged than a reference and the other more negatively charged than the reference; while by making both beam **430** and side electrode **440** more positively (or negatively) charged than a reference, the tip of the actuating beam can be actuated in the direction away from side electrode **450.** As above, the tip may also be actuated away from side electrode **450** by its inherent elasticity, or by being pulled electrostatically by another electrode. As will be appreciated by those skilled in the art, integrated circuitry for generating the above-described electrostatic forces, for example using voltage pulse signals, may be readily and conveniently provided in substrate **102.** Furthermore, to provide the desired actuation of beams **430,** electrodes could be positioned at both sides of an actuating beam, and it is also possible to provide an electrode above each actuating beam **430** (in addition to or instead of bottom electrode **440).**

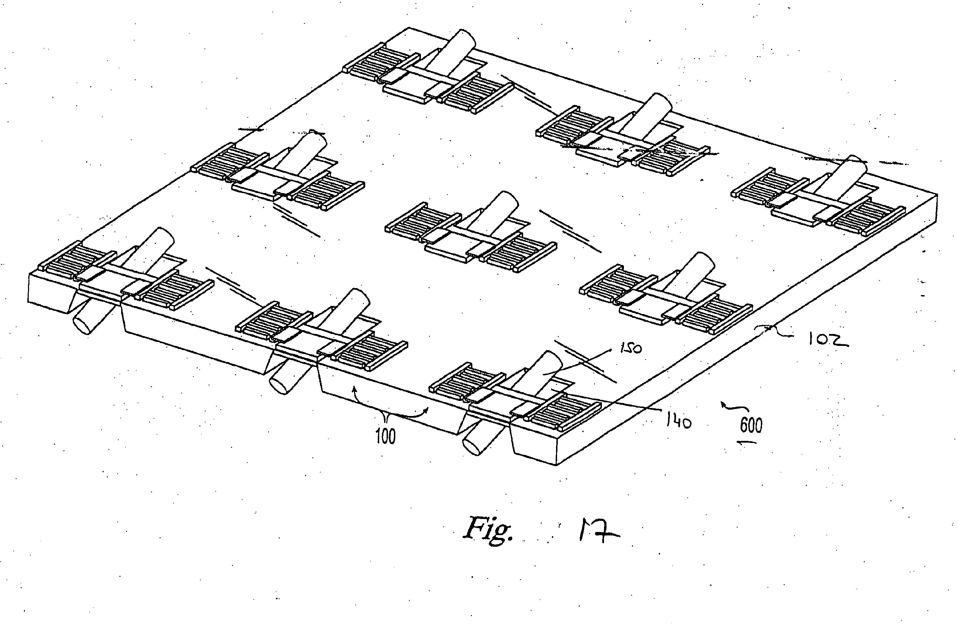

As illustrated in Figs. 8 and 10A-108, corresponding bottom and side electrodes **440** and **450** preferably extend in parallel along a considerable portion of each beam **430.** The stress in beams **430** is low during actuation since only relatively small displacements are required. Also, the tips of beams **430** preferably remain generally parallel to the surface **104** of substrate **102,** as illustrated by Fig. 9A, which shows a cross-sectional side view of the MEMS device of Fig. 8 with opposing beams **430** in an unactuated position, and Fig. 9B, which shows the same cross-sectional side view with the opposing beams **430** in actuated towards substrate **102.** Furthermore, it should be pointed out that a side electrode **450** is generally positioned in close proximity to its corresponding beam **430,** while being far enough way from the next closest beam **430** so that any electrostatic force between the side electrode **450** and the next closest beam is negligible. In this manner, a particular side electrode only serves to actuate the beam corresponding thereto.

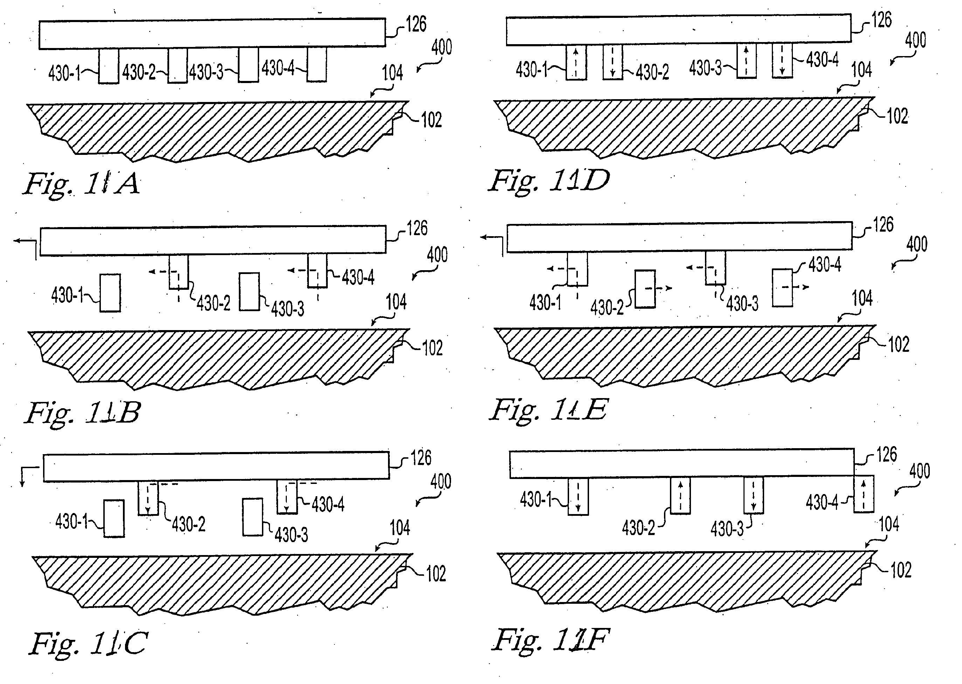

Figs. 11A-11F illustrate the operation of beam actuator **400** illustrated in Fig. 8. In general, beams **430** in set **410** are actuated synchronously or in tandem with corresponding beams in set **420,** so that moving element **106** is transported in a straight path, as shown in Fig. 8. Figs. 11A-11F show the actuation of the tips of four beams **430-1, 430-2, 430-3,** and **430-4** in one of sets **410** or **420.** As indicated, each set **410** and **420** may include any number of beams **430,** but generally only a subset of those beams holds mirror element wing **126** at any one time.

In Fig. 11A, the tips of beams **430-1, 430-2, 430-3,** and **430-4** are in a first level position in which all four beam tips are at the same height above substrate **102** and all four beam tips are supporting wing **126** of moving element **106.** Preferably, when moving element **106** is in a desired operative position, beams **430-1, 430-2, 430-3,** and **430-4** are in such a level position. Referring to Fig. 11B, upon actuation, the tips of beams **430-2** and **430-4** begin to move away from substrate **102** so that only members **430-2** and **430-4** support wing **126.** Subsequently, the tips of beams **430-2** and **430-4** begin to be actuated to the left in Fig. 11B. As the tips of beams **430-2** and **430-4** move to the left in Fig. 11B, wing **126** is transported in the same direction. Since a corresponding actuation takes place simultaneously with respect to the other wing **126** of moving element **106,** element **106** is thereby transported by actuator **400** in the same desired direction.

Next, referring to Fig. 11C, the upward actuation of the tips of beams **430-2** and **430-4** ceases and those beam tips move back down and toward substrate **102** until a second level position is reached in Fig. 11D. As with the first level position of Fig. 11A, all four beam tips support wing **126** of moving element **106** in the second level position of Fig. 11D, and moving element **106** lies in the same horizontal plane as in Fig. 11A. The tips of beams **430-1** and **430-3** are then actuated up and away from substrate **102** so that they begin to support wing **126** on their own. The tips of beams **430-1** and **430-3** are subsequently actuated to the left as shown in Fig. 11E, with wing **126** and element **106** moving in tandem. At the same time, the sideways or leftward actuation of beams **430-2** and **430-4** ends and these beam tips retreat, without affecting the movement of element **106** (see Fig. 11E), to their unactuated level position in Fig. 11A. The upward actuation of the tips of beams **430-1** and **430-4** ends and these beam tips move down and toward substrate **102** until, in Fig. 11F, the tips of all four beams **430-1, 430-2, 430-3,** and **430-4** are all again in a level position. This process repeats itself until moving element **106** has moved to the desired operative position. As wing **126** moves outside the range of a particular beam tip, e.g. that of beam **430-4** in Fig. 11F, the actuation of that beam tip may end. Correspondingly, when wing **126** has moved on top or within range of another beam tip, e.g. that of a beam immediately to the left of beam **430-1** in Fig. 11F, that beam tip begins to be actuated as described above.

As illustrated in Figs. 11A-11F, the tips of alternate beams effectively undergo a rotation-like motion to successively and repeatedly actuate moving element **106.** In the illustrated embodiment of Figs 11A-11F, the rotation of the tips of the first pair of beams **430-1** and **430-3** and the rotation of tips of the second pair of beams **430-2** and **430-4** (both counter-clockwise in Figs 11A-11F) are out of phase so that each pair successively acts to transport moving element in the desired direction. The amount of motion in each step depends on the horizontal amplitude of the beams. For example, a 2 x 2 µm beam that is 150 µm long preferably has a horizontal and vertical amplitude of about 1 µm (or less). Also, although, as illustrated in Figs. 11A-11F, the rotation-like motion of the beams is preferably rectilinear, it may also be circular or elliptical, for instance. Furthermore, to move element **106** in the reverse direction, the rotation of the beam tips can simply be reversed.

If more than four beams **430** are underneath wing **126** of element **106** at a given position, the actuated motion of the beam tips may be more complex. For example, with six beam tips underneath wing **126** at a given position, the beam tips may be actuated as three separate groups or pairs whose rotation-like motions are generally 120° out of phase with one another.

As described, electrostatic beam actuation is preferably used because of the efficiency and ease of implementation of electrostatic forces in a microelectromechanical system. In particular, by controlling or modulating the timing and duration of voltage pulse signals applied to beams **430,** bottom electrodes **440,** and side electrodes **450,** the tips of the actuating beams may be controllably rotated in a clockwise or anti-clockwise direction, translating moving element **106** as described above. Associated control circuitry used for this purpose is preferably microelectronically implemented within MEMS device **100,** using convention integrated circuit fabrication techniques well known in the art. The frequency and phase relationship between applied voltage pulse signals, controls the direction and travelling speed of the movement of element **106.** However, as indicated above, in the beam actuator embodiments described above and variations thereof, the rotation-like actuation of the beams **430** can be achieved by any of the different actuation methods described in the parent application and above. For example, beams **430** may comprise a piezoelectric crystalline material. In this case, by applying appropriate voltage pulse signals to the piezoelectric beams, they may be manipulated to mechanically bend in the horizontal and vertical directions, and thereby transport moving element **106** in a desired direction in the manner just described. As will be appreciated, the orientation and structure of beams **430** may vary, in particular depending on the type of actuation method used.

Thus, generally, in actuator **400** a plurality of elongated actuating beams **430** are spaced perpendicularly to the travel path of the moving element **106.** Each beam **430** extends above and preferably substantially parallel to surface **104** of substrate **102,** and each beam has a base rigidly fixed with respect to substrate **102** (i.e. via anchor portion **460)** and a tip that is preferably proximate or near an edge **406** of the moving element's travel path. Actuator **400** controllably causes the tips of the actuating beams **430** to rotate, so that the tips of the actuating beams that are located along the edge of the portion of the travel path in which the moving element is located intermittently engage the moving element. By intermittently engaging moving element **106** during their rotation, the tips serve to actuate the moving element in a desired direction along the travel path. Furthermore, it will be appreciated that actuator **400** can be adapted to actuate element **106** along other types of travel paths. For example, if moving element **106** is sector-shaped and moves in a radial or pendulum-like motion about a point **120** (see Fig. 3), beams **430** may be positioned to extend perpendicularly to and along substantially the entire radial travel path of element **106** (with element **106** rotatably fixed with respect to substrate **102** at point **120).** In this case, only a single set of actuating beams **430** is required since the travel path only has a single, arc-shaped, outer edge.

To summarize, and using the clockwise movement as exemplary, the preferred movement of a valve over one cycle includes four principal steps: 1) separating the valve from its rest element by raising it above the substrate; 2) moving the valve to the right; 3) lowering the valve toward the substrate; and 4) placing the valve on the rest element, separating the beams from the valve, and moving the beams back to the left. A similar movement can occur counterclockwise. Step 4 does not return the valve to its original position, but leaves it displaced laterally by one "step" of typically 1 µm from the starting point of the cycle. This movement is similar to that of the tracks of a half-track vehicle. The actuation allowing such "half-track" movement is typically driven by three-level (preferably +60V, 0V and -60V) voltage pulses from four independent sources. The alternating positive and negative voltage cycles are symmetrical and fulfill an important function of discharging (or preventing the build-up of) any parasitical charges that may be created on the actuators by the use of a single type polarity.

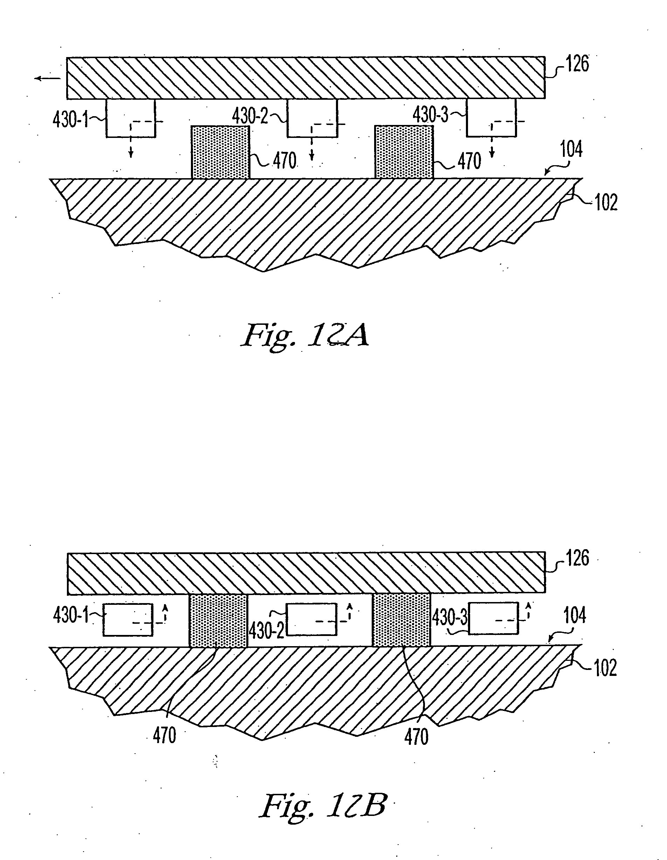

Figs. 12A-12B illustrate a possible modification to the operation of the actuator **400.** In the actuator embodiment of Figs. 12A-12B, the tips of the beams **430-1, 430-2, 430-3** in beam set **410** (and beam set **420)** rotate in unison, i.e. all in phase with one another. When moving element **106** is in a static operative position, wings **126** and/or element **106** are supported by fixed posts **470.** Posts **470** preferably extend upwardly from surface **104** of substrate **102,** but optionally posts **470** may be replaced with static beams that are not actuated. As shown in Fig. 12A, during actuation, the tips of beams **430-1, 430-2** and **430-3** begin a rotation-like motion in which they are first actuated upwards (away from substrate **102)** so that the tips rise above the level of posts **470,** lifting wing **126** off posts **470.** Subsequently, the beam tips are actuated in parallel to substrate **102,** transporting moving element **106** in a desired direction (to the left in Fig. 12A). As the rotation-like motion of the tips of beams **430-1, 430-2, 430-3** continues, the upward actuation of the tips ends, so that the beam tips retreat or fall below the level of static posts **470** (see Fig. 12B). When this occurs, wing **126** is again held and supported by posts **470,** although now at a different position in the horizontal plane above substrate **102.** The sideways actuation of the tips of beams **430-1, 430-2, 430-3** also ceases at this stage. This rotation-like cycle is repeated until moving element **106** has been re-positioned to a desired operative location.

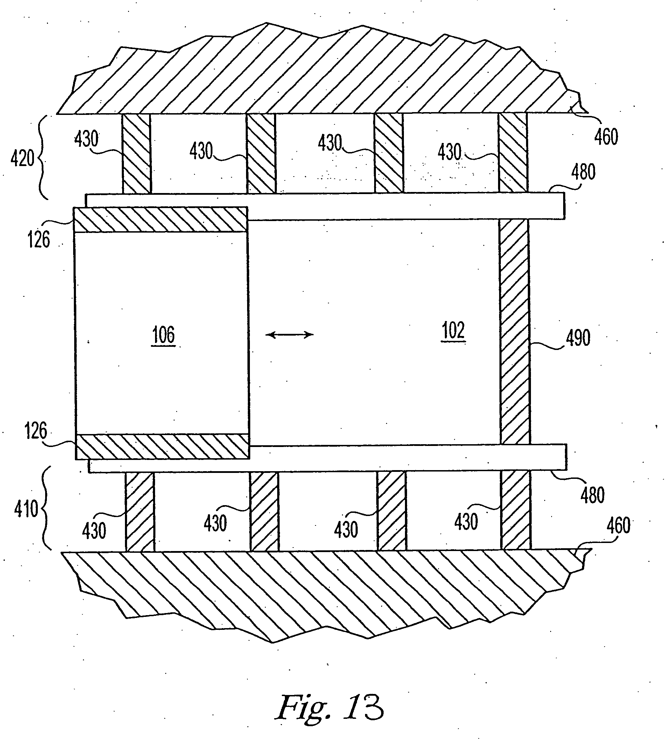

Fig. 13 illustrates a possible adaptation of an actuator **400** operating as described in connection with Figs. 12A-12B which serves to ensure that the motion of element **106** is linear and that element **106** is not undesirably tilted. As described above, element **106** is actuated at opposite ends by two synchronously operating sets **410** and **420** of beams **430** extending from base portions **460.** As shown in Fig. 13, the tips of beams **430** in each set **410** and **420** are connected to a connecting support beam **480** that supports and holds a wing **126** of element **106.** Connecting support beams **480** increase the cumulative actuation force generated by the individual tips of beams **430** and also act to further synchronize the operation and movement of the beam tips. As a result, moving element **106** is evenly held and supported from both sides. In the embodiment of Fig. 13, the tips of all beams in each group are actuated in phase during actuation of moving element **106,** regardless of the position of element **106** within its range of travel. One or more additional synchronization beams **490,** linking the connecting support beams **480,** may also be used to further synchronize the actuation operation of each set **410, 420** of beams **430.** Preferably, at least two synchronization beams **490** are used, one near each end of beams **480** (only one beam **490** is shown in Fig. 13).

Furthermore, as will be appreciated, it is also possible to rotate moving element **106** in the horizontal plane by, for example, operating the two sets **410, 420** of beams **430** out of phase. Other types of more complicated movements of element **106** may also be achieved by combining additional sets of beams in different possible configurations and synchronizing those beam sets accordingly.

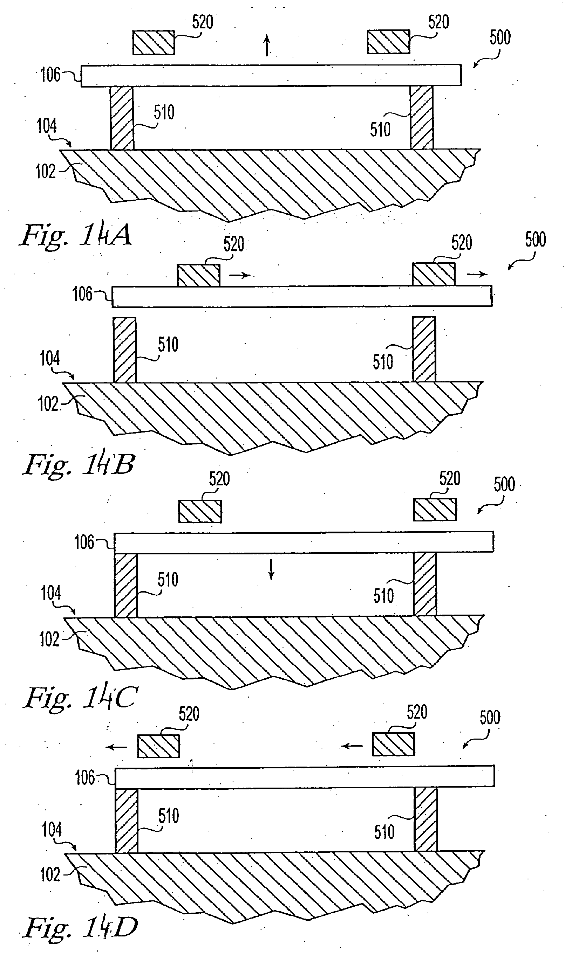

Figs. 14A-14D illustrate the operation of another possible actuator **500** for use in MEMS device **100** of the present invention. In this embodiment, when element 106 is in an operative position, e.g. any position out of 300 stable positions defined between a fully "closed" and a fully "open" position for a variable attenuator or beam splitter MEMS device **100,** element **106** is held on static posts **510** extending from surface **104** of substrate **102,** as shown in Fig. 14A. Alternatively, moving element **106** may have legs **510** that rest on surface **104** of substrate **102.** Actuator **500** further includes beams **520** whose tips are located above and apart from moving element **106** (or a wing or other appendage thereof) when the latter is in an un-actuated or operative state. As with actuator **400** described above, beams **520** are preferably attached to substrate **102** by way of an anchor or base portion (not shown). Upon actuation, moving element **106** is raised from the posts **510** and attaches to beams **520.** Preferably, beams **520** are conductive allowing an attractive electrostatic force to be generated between beams **520** and a conducting component of element **106** (also not shown). However, magnetic attraction may also be used for this purpose. Beams **520** are preferably relatively rigid in vertical direction, so that the tips of beams **520** do not bend substantially when attracting element **106.** Once element **106** is attached to the tips of beams **520,** the tips of beams **520** are actuated in a desired horizontal or sideways direction (Fig. 14B). The combination of the attraction of element **106** and actuation of the tips of beams **520** moves element **106** in a desired direction.

Once element **106** is moved to a desired horizontal location, the attraction between beams **520** and element **106** is ended so that moving element **106** is released and again held by posts **510,** as shown in Fig. 14C. The actuation of the tips of beams **520** also ceases so that they return to their unactuated position. If element **106** is to be moved further in the same direction, the above actuation steps are repeated. Once again, it should be clear that in this embodiment, as with all of the embodiments of the present invention, the terms "up", "down", "lower", "upper", "top", and "bottom" are used merely for illustrative purposes, and that MEMS device **100** can operate independently of its overall orientation.

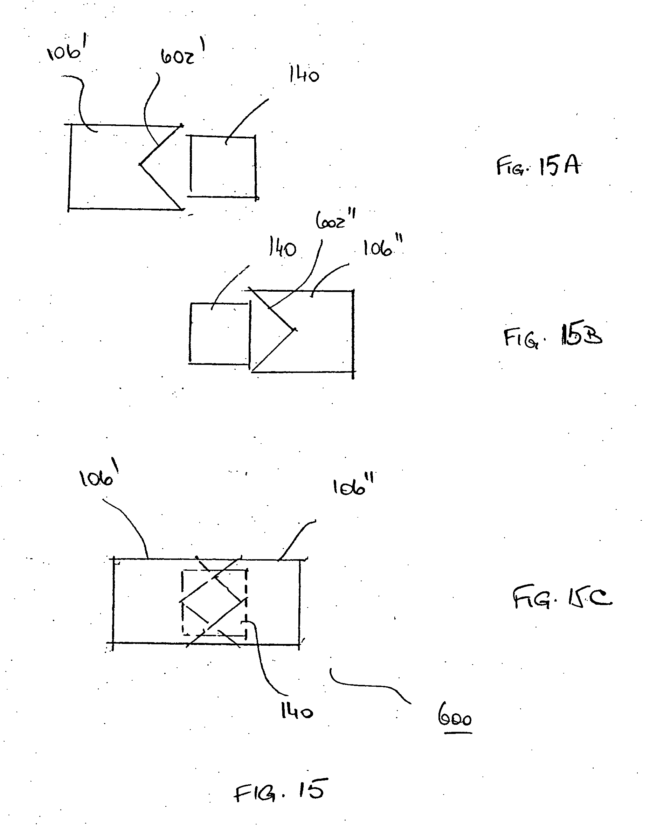

Another preferred embodiment of the present invention uses two or more moving elements or valves in conjunction with one aperture. The two or more moving elements or valves are positioned on different planes above, and preferably on opposite sides of the aperture, each valve covering only part of the aperture. An example of such a two-valve unit **600,** in which the shape of the valve (in addition to the degree of overlap with the aperture) is also involved in controlling the attenuation function is shown in Fig. 15.

The two-valve unit **600** uses two moving elements similar to element **106** located in two different layers. Fig. 15A shows in top view a first valve **106'.** Valve **106'** is located for example to the left and above the plane of a transparent zone **140.** FIG. 15B shows a top view of a second valve **106",** located for example to the right and above zone **140,** in a plane higher than and parallel with valve **106'.** Valves **106'** and **106"** have respective leading edges **602'** and **602"** which may be straight, as in the preferred embodiment of an element **106.** Preferably, edges **602'** and **602"** are shaped with shapes which provide a uniform attenuation to a light beam. For example, as shown in Figs. 15A-B, edges **602'** and **602"** are each shaped as a "V". If a perpendicular Gaussian shaped beam is directed toward, and centered in zone **140,** its peripheral sections can be progressively and uniformly blocked by controllably moving both valves one toward the other, using the innovative stepped movement of the present invention. In a preferred stable position, only the central part of the beam is allowed to pass through zone **140.** Such an intermediate, partially blocking or attenuating position is shown in FIG. 15C. Alternatively, if the starting position is one in which the two valves completely block the beam, by controllably moving them apart from each other, the peripheral sections of the beam are increasingly allowed through zone **140.** Those skilled in the art will appreciate that more than two valves, moving in different but parallel planes and having different leading edge profiles and different movement directions, can be used to control the attenuation function.

The attenuation function as a function of the movement is not linear, but there are a number of ways to overcome this non-linearity. For example, a LUT can be used to store the values of the necessary movement of each valve for a given attenuation factor.

The fabrication of MEMS device **100** and its various components may be achieved using conventional macromachining, mesomachining, or micromachining techniques. Preferably, micromachining technology including the well-known photolithography, deposition, and etching fabrication methods used in the microelectronics and micromachining industries is used to manufacture all of the components of device **100.** See generally, Chertkow et al., "Opportunities and Limitations of Existing MicroFabrication Methods for Microelectromechanical Devices", Proc. 25^{th} Israel Conf. on Mechanical Engineering, Technion City, Haifa, Israel, p. 431 (May 1994) and Petersen, "Silicon as a Mechanical Material", *Proceedings of the IEEE,* vol. 70, no. 5 (May 1982), the contents of which are hereby incorporated herein by virtue of this reference. Batch manufacturing of MEMS devices in integrated circuit fabs or foundries permits the production of large volumes of devices at extremely low cost.

Micromachining fabrication technology includes both bulk and surface micromachining processes. With bulk micromachining techniques, microstructures are formed by etching away the bulk of a silicon wafer to produce the desired structure. On the other hand, surface micromachining techniques build up the structure in layers of thin films on the surface of a suitable wafer substrate. Typically, films of a structural material and a sacrificial material are deposited and etched in sequence. Generally. the more mechanical layers used during surface micromachining, the more complex the structure and the more difficult fabrication becomes. Once the desired structure has been formed, the sacrificial material is etched away to release the structure. Due to its mechanical properties and compatibility with modem integrated circuit fabrication processes, polysilicon, i.e. polycrystalline silicon, is preferably used as the MEMS structural material. Polysilicon is strong, flexible, fatigue-resistant, and highly compatible with integrated circuit fabrication techniques.

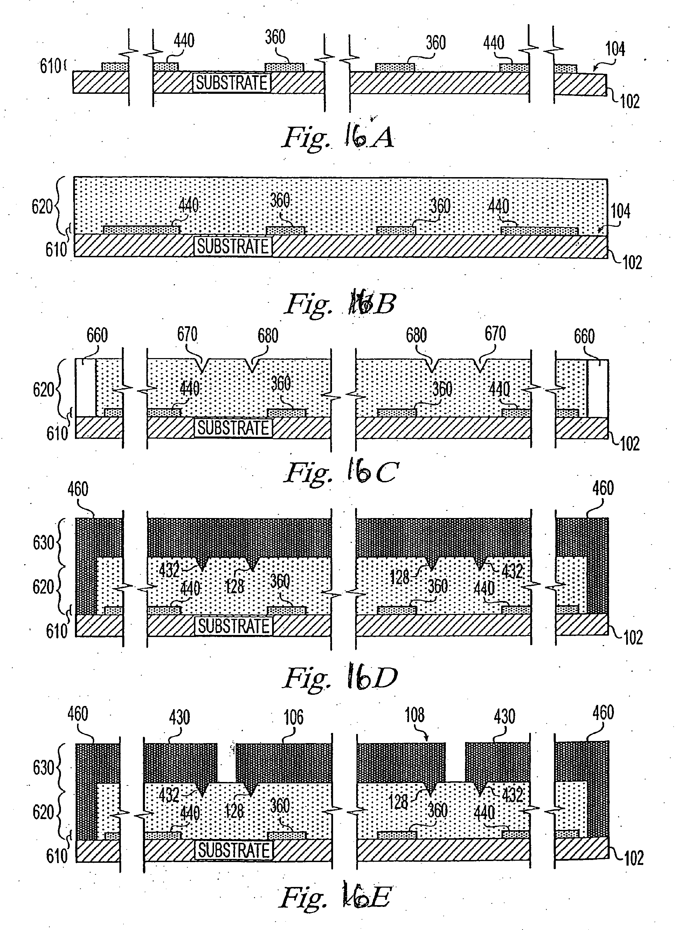

MEMS device **100** is preferably built using this type of sacrificial polysilicon surface Micromachining technology, which as described above, enables the mass production of complex microelectromechanical systems, by themselves or integrated with microelectronics. Figs. 16A-16I illustrate a preferred method of fabricating the mechanical structure of the MEMS device **100,** including actuator **400,** of Fig. 8 using surface micromachining techniques. More specifically, Figs. 16-16I show a cross-sectional side view of device **100** during the various steps in the fabrication process.

Before micromachining begins, substrate **102** is selected and prepared. Generally, substrates of different materials, dimensions, thickness, and surface preparation may be used, although the physical dimensions of substrate **102** may be dictated by the purpose and operation of device **100.** Furthermore, as described above, in the case of an optical switch device part of substrate **102** may be removed (bulk etched) to provide a transparent or penetrable zone **140** in substrate **102** (see Fig. 4). Furthermore, where MEMS device **100** is an optical switch and moving element **106** is a mirror, the surface preparation of substrate **102** (including surface **104)** is preferably of high quality so that the reflective surface **108** (see Fig. 1) of the mirror can also be provided with a high degree of surface quality, especially in terms of flatness and parallelism.

Once a suitable substrate **102** has been prepared, a first polysilicon layer **610** is deposited on the surface **104** thereof. Polysilicon layer **610** is photolithographically patterned before undergoing chemical etching. As is well known in integrated circuit fabrication processes, a two-dimensional mask may be used to define the patterns to be etched. As illustrated in Fig. 16A, the deposition and patterning of polysilicon layer **610** forms bottom electrodes **440** and substrate electrodes **360** used for electrostatic attachment. In Fig. 16B, an oxide (e.g. silicon dioxide) layer **620** is deposited on top of substrate **102** and the remaining polysilicon layer **610.** Oxide layer **620** is then patterned and etched to provide slots **660** for the subsequent deposition of anchor portions **460,** dimples **670** for fin legs 432 of beams **430,** and dimples **680** for fin legs **128** of moving element **106**. This is shown in Fig. 16C.

In Fig. 16D, a second polysilicon layer **630** is deposited on top of oxide layer **620** and into slots **660, 670,** and **680** to form anchor portions **460,** fin legs **432,** and fin legs **128** respectively. Further patterning and etching of polysilicon layer **630** produces beams **430** and moving element **106,** as shown in Fig. 16E. Where moving element 106 is a mirror, its top surface **108** may be coated with gold or aluminium, for example, using standard deposition and patterning methods to render surface **108** reflective. As indicated, to minimize losses, any mirror or other optical element used in MEMS device **100** should be designed to be very smooth. Furthermore, as described in detail above, in the case of an optical switch, the mirror is provided above substrate **102** in an area in which input light beams will be directed, below which substrate **102** is either absent or transparent. However, for other types of MEMS devices moving element **106** may be fabricated in other positions above substrate **102.**

In Fig. 16F, a further oxide layer **640** is deposited, as shown. Patterning and etching of layer **640** is carried out to provide slots **690** for wings **126** of moving element **106.** Polysilicon layer **650** is subsequently deposited, as shown in Fig. 16G; and patterning and etching of layer **650** results in wings **126,** as shown in Fig. 16H. At this stage, the deposition and patterning of the mechanical layers is complete. As a result, in Fig. 16I, the remainder of oxide layers **620** and **640** is chemically removed, leaving behind the desired polysilicon mechanical structures. Alternatively, release of the mechanical structures may be accomplished by etching steps.

In general, fabrication of the associated microelectronics (not shown) for MEMS device **100** may be performed simultaneously with, before, or after, the above-described surface machining steps. It will be appreciated that alternative and further fabrication steps will be required for different types of actuators and/or different types of actuation and/or attachment principles. In addition, different configurations and applications of MEMS device **100** may alter or vary the fabrication details and materials used. Furthermore, other fabrication processes may also be used, although it is highly preferable that the fabrication of moving element **106** take place above the highly smooth and planar surface **104** of substrate **102,** as explained above.

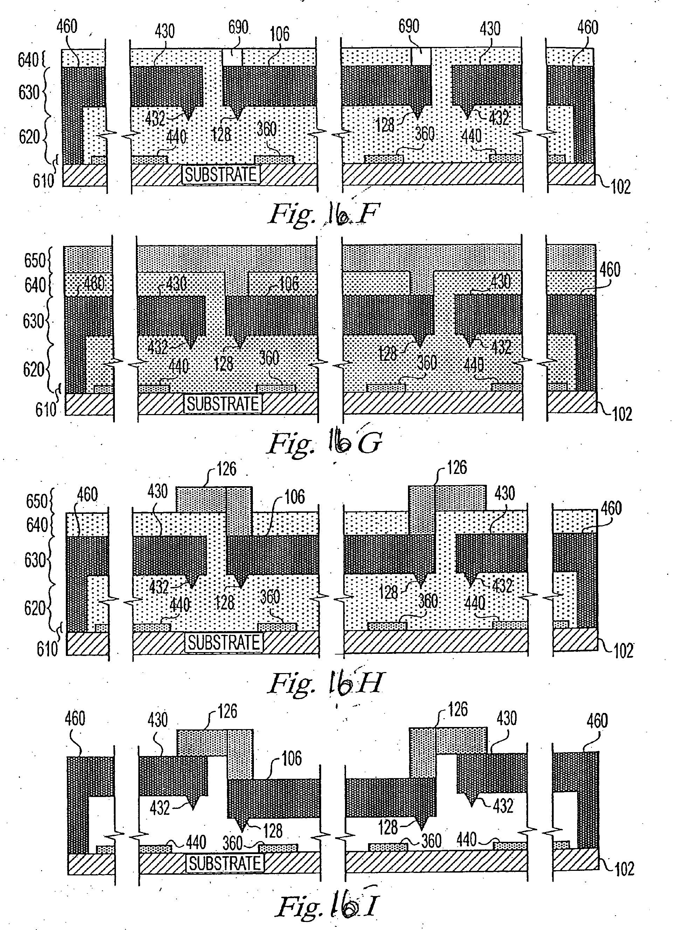

It will be appreciated that the present invention is capable of providing attenuating/splitting devices with a number of inputs M and outputs N for a variety of applications, by employing a plurality of variable attenuators/splitters. Preferably, the moving elements in the attenuators/splitters are actuated and move in directions that are parallel to one another. For example, the attenuators/splitters may share a common substrate so that the moving elements of each attenuator/splitter are generally coplanar. Fig. 17 shows an isomeric view of such a two-dimensional attenuating/splitting device comprising a 3 x 3 array **800** of devices **100.** Array **800** is shown having only 9 devices **100** configured in a 3X3 array by way of example only, and for convenience of presentation. It is understood that an array of the present invention can have a plurality of other than nine variable beam splitter/attenuators **100,** and that devices **100** do not necessarily have to be configured in an array comprising equal numbers of elements in each row or column. Devices **100** provide a 3 x 3 array of inputs and outputs arranged in rows and columns. Each optical attenuator/splitter is shown in Fig. 17 in an OFF position in which input beam **150** travels through penetrable zone **140** of substrate **102** comprising a hole or aperture formed within the substrate.

It will be appreciated that the MEMS device of present invention, which includes a generally flat moving element such as a mirror disposed horizontally above a smooth wafer substrate, provides several advantages. The device **100** allows for a fast actuation response, low losses, compact structure, and relatively large actuation displacements, unlike prior art devices that form the moving element by etching into the substrate wafer. The actuation of the moving element in the present invention effectively occurs in parallel to the substrate as a translation, thus minimizing any air resistance and providing more favourable actuation performance from the standpoint of inertia and energy considerations. Importantly, because of the high degree of planarity of substrate **102** and moving element **106** during fabrication, the design and positioning of the moving element in the present invention avoids small deviations that can significantly affect device operation accuracy, as may occur in prior art devices in which a moving element or mirror is disposed vertically with respect to the substrate or in prior art devices in which the moving element tilts with respect to the substrate. As indicated, MEMS device **100** may have a relatively long travel path, so that there is no overlap between operative positions of moving element **106** in terms of the location of these positions in the plane above substrate **102.**

While preferred actuation embodiments uses actuating beams to translate the moving element from one operative or "stable" position in a horizontal plane above the substrate to another operative position in that horizontal plane, actuators based on other actuation techniques can also be used. In addition the physical phenomenon used to generate the required actuation forces may be based on various physical principles including: thermomechanical; shape memory alloys (SMA) and thermal actuation; electromagnetic; electrostatic; elasticity; or piezoelectric, magnetic, diamagnetic, mechanical, or material phase change. Also, while the moving element is preferably held by static friction induced by an electrostatic or magnetic force, as described above, other support and attachment configurations for the moving element may also be used.

MEMS device **100** may be advantageously implemented for other applications relating to fiber optic communication, such as optical switches, valves, collimators, and the like. In particular, as indicated in the parent application, MEMS device **100** of the present invention can be used as an optical switching element. Use of the preferred actuators and preferred mechanisms for attaching moving element **106** permits the device to be actuated and used as variable attenuators and beam splitters with milisecond speed of movement between operative positions, and with minimal dynamical friction thereby reducing wear and increasing reliability.

Thus generally, while the invention has been described in conjunction with specific embodiments, it is evident that numerous alternatives, modifications, and variations will be apparent to those skilled in the art in light of the foregoing description.

## Claims

1. A microelectromechanical (MEMS) device comprising:
(a) a substrate having a surface;
(b) at least one generally planar moving element disposed in parallel to said surface of said substrate; and
(c) an actuator operatively engageable with said at least one moving element for selectively moving said at least one element between a series of successive closely spaced operative positions in a plane horizontal to said surface of said substrate.

2. The MEMS device of claim 1 wherein said at least one moving element includes means for altering the characteristics of a wave signal incident thereupon.

3. The MEMS device of claim 2 wherein said wave signal is an optical beam and said at least one moving element alters characteristics of said optical beam in a stepped varying fashion when moving between said operative positions.

4. The MEMS device of claim 2 wherein said substrate includes a zone that is penetrable by said optical beam, and wherein said optical beam characteristics are altered by a degree dependent on the positioning of said at least one movable element along said operating positions, when said optical beam is passing through said penetrable zone.

5. The MEMS device of claim 4 wherein said characteristics are chosen from the group consisting of intensity and shape.

6. The MEMS device of claim 2, wherein said means include a shaped leading edge.

7. The MEMS device of claim 6, wherein said shaped leading edge is V-shaped.

8. The MEMS device of claim 4 wherein said penetrable zone is an aperture formed within said substrate.

9. The MEMS device of claim 4 wherein said penetrable zone comprises an optically transparent material.

10. The MEMS device of claim 1 wherein said actuator moves said at least one moving element in a linear path between said operative positions.

11. The MEMS device of claim 3 wherein said at least one moving element is a mirror, said mirror allowing transmission of a first portion of said optical beam into a first output beam and reflecting a second portion of said optical beam into a second output beam, said first and second portions depending on said operative positions.

12. The MEMS device of claim 1 wherein said at least one moving element includes a conductive component and the device further comprises: at least one substrate electrode and circuitry for generating an electric field between said conductive component and the at least one substrate electrode to hold said at least one moving element by means of static friction.

13. The MEMS device of claim 1 wherein said at least one moving element includes a conductive component and the device further comprises: a first substrate electrode, a second substrate electrode, and circuitry for generating an electric field between said first substrate electrode and said second substrate electrode; whereby said electric field induces a further electric field between said conductive component and at least one of the first and second substrate electrodes to hold said at least one moving element by means of static friction.

14. The MEMS device of claim 1 wherein said actuator comprises:
a) a plurality of elongated actuating beams spaced perpendicularly to and along a travel path of said at least one moving element, each beam having a tip and a base that is rigidly fixed with respect to said substrate; and
b) a beam actuator for controllably moving said actuating beams so that the beams that are positioned along the portion of the travel path in which said at least one moving element is located intermittently engage said moving element and thereby move said moving element in a desired direction along said travel path.

15. The MEMS device of claim 14 wherein said beams are conductive and said beam actuator comprises, for each actuating beam:
a) at least one first electrode connected to said substrate and positioned vertically from said actuating beam with respect to a surface of said substrate;
b) at least one second electrode connected to said substrate and positioned horizontally from said actuating beam with respect to said surface of said substrate; and
c) circuitry for controllably generating a first electric field between said at least one first electrode and said actuating beam to move said actuating beam in a vertical direction with respect to said surface of said substrate, and a second electric field between said at least one second electrode and said actuating beam to move said actuating beam in a horizontal direction with respect to said surface of the substrate.

16. The MEMS device of claim 14 wherein said travel path is linear and has first and second edges, and wherein said plurality of actuating beams comprises: a first set of actuating beams spaced along said first edge of said travel path; and a second set of actuating beams spaced along said second edge of said travel path, said beam actuator controllably moving said tips of said beams in said first set synchronously with said tips of said beams in said second set.

17. The MEMS device of claim 16 wherein said tips of said first set of actuating beams are located proximate to said first edge of said travel path; and said tips of said second set of actuating beams are located proximate to said second edge of said travel path.

18. The MEMS device of claim 1 wherein said at least one moving element rests on static support members fixed to said substrate, said at least one moving element has a travel path between said successive operating positions, and said actuator comprises:
a) a plurality of elongated actuating beams spaced perpendicularly to and along an edge of said travel path of said at least one moving element, each beam extending substantially parallel to the surface of said substrate and having a tip and a base rigidly fixed with respect to said substrate;
b) beam attachment means for controllably holding said at least one moving element to said actuating beams that are located along the edge of the portion of said travel path in which said at least one moving element is located; and
c) a beam tip actuator for controllably moving said actuating beams, when said at least one moving element is being held thereto, in a desired direction along said travel path.

19. An array of microelectromechanical (MEMS) devices on a substrate having a surface, each of the MEMS devices comprising:
(a) at least one generally planar moving element disposed in parallel to said surface of said substrate; and
(b) an actuator operatively engageable with said at least one moving element for selectively moving said at least one element between successive, closely spaced operating positions in a plane horizontal to said surface of said substrate.

20. The array of claim 19 wherein each said at least one moving element includes means for altering the characteristics of a wave signal incident thereupon.

21. The array of claim 20 wherein the wave signals are optical beams and, for each MEMS device, said substrate includes a zone which is penetrable by said optical beam and wherein said optical beam is directed at that MEMS device so that said optical beam is attenuated when passing through said penetrable zone by a degree dependent on the positioning of said at least one movable element along said operating positions.
